# EUROPEAN PATENT SPECIFICATION

(11) **EP 2 757 572 B1**
(45) Date of publication and mention of the grant of the patent: **03.06.2020**
(21) Application number: 12831362.4
(22) Date of filing: 23.08.2012
(51) Int. Cl.: H01J 37/20

(54) **SAMPLE HEATING METHOD USING SAMPLE HEATING HOLDER FOR ELECTRON BEAM MICROSCOPES OR ANALYZERS**
PROBENERWÄRMUNGSVERFAHREN MIT PROBENERWÄRMUNGSHALTER FÜR ELEKTRONENSTRAHLMIKROSKOPE ODER ANALYSATOREN
PROCÉDÉ DE CHAUFFAGE D'ÉCHANTILLONS UTILISANT PORTE-ÉCHANTILLON CHAUFFANT POUR MICROSCOPE OU ÉQUIPEMENT D'ANALYSE UTILISANT UN FAISCEAU D'ÉLECTRONS

(30) Priority: 14.09.2011 JP 2011200053
(43) Date of publication of application: 23.07.2014
(73) Proprietor: JFE Steel Corporation, Tokyo 100-0011 (JP)
(72) Inventor: YAMASHITA,Takako, Tokyo 100-0011 (JP); NORO, Hisato, Tokyo 100-0011 (JP); SEKIMOTO, Mitsuyoshi, Tokyo 100-0011 (JP); WATANABE, Manabu, Tokyo 100-0011 (JP); KAJIMA, Yoshihisa, Tokyo 100-0011 (JP)
(74) Representative: Haseltine Lake Kempner LLP
(86) International application number: PCT/JP2012/071924
(87) International publication number: WO 2013/038910

(56) References cited:
- EP-A1- 2 278 306
- WO-A1-2011/043344
- JP-A- H0 274 026
- JP-A- H05 215 702
- JP-A- H11 116 209
- JP-A- 2000 133 189
- JP-A- 2004 063 463
- JP-A- 2007 149 449
- JP-A- 2007 149 449
- JP-A- 2011 034 895
- JP-A- 2011 034 895
- US-A- 3 418 465
- US-A- 3 996 447
- US-A1- 2007 120 068
- US-A1- 2008 179 518
- Anonymous: "Titannitrid - Wikipedia", , 25 August 2011 (2011-08-25), XP055315165, Retrieved from the Internet: URL:https://de.wikipedia.org/w/index.php?t itle=Titannitrid&oldid=92866320 [retrieved on 2016-10-31]
- Anonymous: "HP Series of PTC Heaters", , 7 August 2009 (2009-08-07), XP55583429, Retrieved from the Internet: URL:https://web.archive.org/web/2009080703 5826if_/http://www.farnell.com:80/datashee ts/11488.pdf [retrieved on 2019-04-25]

## Description

### . [Technical Field]

The present invention relates to a sample heating method for electron beam microscopes or analyzers such as electron microscopes and electron beam microanalyzers

### [Background Art]

Electron beam microscopes or analyzers such as scanning electron microscopes, transmission electron microscopes, electron beam microanalyzers and Auger electron spectrometers are utilized in microstructural evaluation of materials. Such instruments have a serious problem in that the contrast of images is changed or the accuracy of the analysis of elements such as carbon is lowered due to the occurrence of carbon contaminations (hereinafter, "contaminants") on the sample surface by the interaction of the incident electron beam with pollutants such as hydrocarbons present on or in the vicinity of the surface of the evaluation samples.

The pollutants find their way mainly through four routes: samples, sample holders, vacuum evacuation systems, and inner parts of the devices. The entry of the pollutants through vacuum evacuation systems can be suppressed to a degree by, for example, purging the sample chamber with nitrogen gas, or the use of liquid nitrogen traps or oil-free vacuum pumps. Once the pollutants are brought to the inside of the sample chamber, they are attached or adsorbed to surfaces such as sample chamber walls or a sample holder and become resistant to removal even by high vacuum evacuation. Further, a sample, no matter how clean it is, is contaminated when exposed to air by the adsorption of carbon sources such as hydrocarbons to its surface. Inappropriate pretreatments, handling and storage of samples result in an increase in the amounts of pollutants brought by the samples to the sample chamber.

The molecules of pollutants brought to the inside of a device move about the device via surface diffusion and gas-phase diffusion. Such pollutant molecules which are moving about are finally aggregated to a sample illumination position as if they are drawn to the electron beam, thus forming contaminants. In view of the fact that contaminants are formed in this process, an effective anti-contaminant measure is to remove as much pollutants as possible from the vicinity of a sample or to immobilize the pollutants before the sample is observed and analyzed by the application of electron beam.

Liquid nitrogen traps are the most popular method for removing pollutants present on or in the vicinity of the sample surface. In this method, a cold fin cooled by liquid nitrogen is provided in the vicinity of the sample, and pollutant molecules which have arrived at the fin via gas-phase diffusion and surface diffusion are temporarily trapped. This method cannot remove all the pollutants around the sample, and thus the occurrence of contaminants cannot be prevented perfectly.

Other widely known methods are to evacuate the sample chamber to an ultrahigh degree of vacuum, and to sputter the sample surface with ions such as Ar ions. However, ultrahigh-vacuum evacuation of the sample chamber entails baking operations in which the surrounding of the sample chamber is heated at 100 to 200°C for several hours to several days. This incurs many device restrictions such as that the materials and the analytical spectrometer and electron gun used in the device have to be designed to withstand the baking operations as well as the continuous application of ultrahigh vacuum. Further, because this method does not directly remove pollutants present on the sample surface, the formation of contaminants cannot be suppressed perfectly by this method alone. On the other hand, sputtering with ions such as Ar ions is applicable only to devices which permit mounting of a sputtering ion gun. Further, because this method involves the destruction of the sample surface, its application is limited to cases in which image observation and elementary analysis of the sample surface are not adversely affected by sputtering. Furthermore, this method has to be used in combination with ultrahigh vacuum evacuation of the sample chamber in order to perfectly prevent the growth of contaminants because otherwise pollutant molecules are adsorbed again to the sample surface which has been cleaned by sputtering.

Non Patent Literature 1 and references cited therein propose a technique in which pollutants are removed by applying a low-energy high-frequency reactive gas plasma to a sample and a sample holder. Further, Patent Literatures 1 to 3 propose methods and devices in which an oxygen-containing gas such as air is ionized into a high-frequency plasma producing oxygen radicals, which are applied to the sample surface and its surrounding to oxidize pollutants and convert them into easily removed gases such as H₂O, CO and CO₂.

### [Citation List]

### [Non Patent Literature]

[NPL 1] T. C. Isabell et al: Microsc. Microanal 5, 126 (1999)

### [Patent Literature]

[PTL 1] U.S. Patent No. 6,610,257
[PTL 2] U.S. Patent No. 6,105,589
[PTL 3] U.S. Patent No. 6,452,315

EP2278306 A1 discloses a method for inspecting a sample, and, in particular describes that, on a sample holder, a "resistor can be used ... (for a PTC) to bring a local portion of the sample to a specific temperature".

JP2004063463 A1 discloses to use a DC power supply for a sample heating holder.

US3418645 generally discloses that in an electron microscope, "the contamination can be reduced also by heating the specimen ..., which ... shortens the time the molecules linger on the specimen surface".

### [Summary of Invention]

### [Technical Problem]

However, the techniques described in Non Patent Literature 1 and Patent Literatures 1 to 3 cannot perfectly remove pollutants probably because the plasma or the radicals are not sufficiently applied to the sample and its surrounding, thus failing to prevent stably the occurrence of contaminants on the sample surface.

It is an object of the invention to provide a sample heating method for electron beam microscopes or analyzers which can prevent stably the occurrence of contaminants on the sample surface without entailing ultrahigh vacuum evacuation or destructing the sample surface.

### [Solution to Problem]

The present inventors carried out extensive studies in order to achieve the above object and have found the following as a result.
i) Heating of a sample is effective for preventing the occurrence of contaminants on the sample surface in a high vacuum environment. The reason why the occurrence of contaminants is prevented by the heating of a sample is probably because pollutant molecules which have been adsorbed to the sample surface are forcibly detached by the heat and thus cannot reach the electron beam position via surface diffusion and gas-phase diffusion. In this case, however, the use of usual metallic heater wires including nichrome wires and tungsten wires as heating elements results in the occurrence of a thermal drift which is caused by the thermal expansion of the sample or the sample holder due to instable heating temperatures. Thus, it is difficult to stabilize the image observation position or the elementary analysis position for a period of time from several ten seconds to several minutes which is necessary for recording microscopic images or performing elementary analysis.
ii) In order to suppress the occurrence of a thermal drift, it is effective to use a self-temperature-regulating positive temperature coefficient (PTC) thermistor as a sample heating element.
iii) In particular, it is preferable that the sample be heated by heat generated by passing a direct current through a PTC thermistor.

The present invention has been made based on the above findings.

The invention provides a method for heating a sample in an electron beam microscope or analyzer according to claim 1. In the method, it is preferable that a plasma or oxygen radicals be applied.

### [Advantageous Effects of Invention]

By the use of the inventive sample heating method, it becomes possible to prevent stably the growth of contaminants on the sample surface without destructing the sample surface by treatments such as Ar ion sputtering as well as to suppress the occurrence of a thermal drift in the sample in electron beam devices such as electron microscopes and electron beam microanalyzers which are not in ultrahigh vacuum. Thus, image observation and elementary analysis can be performed with high accuracy.

### [Brief Description of Drawings]

[Fig. 1] Fig. 1 is a diagram illustrating changes with time of integral C intensity when (direct current) heating was performed, when (direct current) heating was performed and oxygen radicals were applied, and when heating was not performed, namely, the sample was untreated.
[Fig. 2] Fig. 2 is a view illustrating a result of image observation with direct current heating.
[Fig. 3] Fig. 3 is a view illustrating a result of image observation with alternate current heating.

### [Description of Embodiments]

As mentioned above, heating of a sample is effective for preventing the occurrence of contaminants on the sample surface in a high vacuum environment. This anti-contaminant effect is obtained at a heating temperature of about 50°C and becomes marked as the temperature is increased. However, an excessively high temperature causes changes in the microstructure or the quality of the sample. Thus, it is necessary that the heating temperature be set in accordance with the types of samples. For example, the heating temperature is preferably about 100°C when inorganic materials or metallic materials are the subjects. This is because changes or deteriorations of the samples are negligible as long as the heating temperature is about 100°C because the element will be diffused to a distance of only 1% or less relative to the crystal grain size during the period of time from several ten seconds to several minutes which is necessary for image observation or elementary analysis. For example, carbon analysis with respect to a steel material including ferrite grains with an average particle diameter of 10 µm will be discussed. Since the diffusion coefficient of carbon at 100°C is about 2 × 10⁻¹⁴ cm²/s, the diffusion distance will be about 85 nm even after heating for as long as 1 hour. Thus, such heating does not cause a problematic reduction of the accuracy in image observation or elementary analysis in a usual analysis time.

When a sample is heated with a usual metallic wire heater such as nichrome wire or tungsten wire in a high vacuum environment, the heat that flows from the heater into the sample and the sample holder does not balance with the heat that flows out to surrounding structures via thermal conduction even with feedback/feed forward control based on temperature measurement. As a result, the temperature of the sample or the sample holder hunts up and down, and this phenomenon results in a thermal drift due to thermal expansion. The occurrence of a thermal drift is problematic in that the field of view is moved during observation to make it difficult to ensure the positional accuracy in image observation or elementary analysis. Thus, the present invention uses a PTC thermistor capable of suppressing temperature changes of itself by itself as the heating element, and thereby suppresses the occurrence of a thermal drift in the sample or the sample holder.

Thermistors are resistors whose electrical resistance varies significantly with temperature, and PTC thermistors are a type of thermistors which increases the electrical resistance with temperature increase. This type of thermistors operates nonlinearly such that the resistance is increased sharply above the Curie temperature. When an electric current is passed therethrough continuously, the thermistors are self-heated and come to allow less current to flow, thereby maintaining a constant temperature. This is how the thermistors function as constant temperature heating elements. In this manner, the PTC thermistors have a self-temperature-regulating function and allow the temperature to be raised rapidly without the occurrence of hunting at the set temperature. Thus, the PTC thermistors serve as highly effective heating elements for the suppression of the occurrence of a thermal drift.

A ceramic PTC thermistor including barium titanate with additives is a suitable PTC thermistor because this thermistor exhibits thermistor characteristics as a result of the phase transition of barium titanate from the stable tetragonal form at room temperature to the stable cubic form at 120°C or above, as well as because the set temperature (the Curie temperature) can be adjusted in the range from less than 100°C to about 300°C by controlling the amounts of the additives.

In the use of the PTC thermistor, it is preferable that the thermistor be allowed to generate heat by passing a direct current therethrough. If an alternate current is used, an alternate current magnetic field is generated around the current flow channel including the thermistor to cause the applied electron beam to be oscillated, thus resulting in problems such as distorted or blurred electron microscope images and misplaced analysis positions. Consequently, serious problems are encountered in the recording of electron microscope images or the analysis of ultrafine regions particularly at a high magnification where the accurate application of the electron beam is important. On the other hand, the use of a direct current is free from such problems because only a static magnetic field is produced.

Further, contaminants can be reduced more stably by using a direct current in combination with the application of plasma or oxygen radicals.

Even if the temperature of the heating element is constant, disadvantages are caused by heat transfer members such as a sample holder holding the heating element which have a large thermal expansion coefficient because their thermal drift is likely to affect the sample immobilized on such members. Thus, it is desirable that low thermal expansion coefficient alloys such as FeNi₃₆ alloy be used for members which are placed in close contact with the sample directly or indirectly and are thus likely to be brought to an elevated temperature by conductive heating.

The use of the PTC thermistor eliminates the need for evacuating the device to an ultrahigh vacuum or performing Ar sputtering, and the sample surface is allowed to remain intact.

### [EXAMPLE 1]

An inventive sample heating method was provided in which a ceramic PTC thermistor having a Curie temperature of 92°C, a service voltage of 100 V and a stable current of 32 mA was immobilized on an existing aluminum sample holder for a scanning electron microscope through a double-sided copper tape (a copper-containing double-sided tape). A comparative PID-controllable sample heating holder was provided in which an insulating-coated nichrome wire heater and a thermocouple were immobilized on the similar aluminum sample holder through the copper tape. The following test was performed using these sample heating holders.

A commercially available specular polished silicon wafer was cleaned with isopropyl alcohol for 10 minutes and was dried in air. This wafer as a sample was immobilized to the heating section of the sample heating holder through the double-sided copper tape, and the holder was set onto the sample stage of scanning electron microscope SUPRA 55VP manufactured by Carl Zeiss. The amounts of contaminants and the amounts of thermal drift at the set temperatures of room temperature (28°C) and 92°C were measured by the methods described below. To each of the sample heating holders, a direct current voltage was applied via a current inlet terminal mounted on the front side of the SUPRA 55VP sample stage. Here, a temperature-controlling microprocessor was connected to the comparative sample heating holder so that the temperature could be PID-controlled at 92°C. The scanning electron microscope was operated under the conditions in which accelerating voltage: 5 kV, probe current: 0.1 nA, electron beam illumination time: 500 sec, and observation magnification: x100000. To avoid any influence of charge up, the sample in each sample heating holder was grounded to the aluminum holder through a commercially available conductive Cu tape.

Amounts of contaminants: With use of an energy dispersive X-ray spectrometer mounted on the scanning electron microscope, the amount of contaminants was evaluated based on the integral intensity of the Kα line of carbon (C) on the sample surface (the peak intensity including the background, referred to simply as "integral C intensity) that was integrated during the electron beam illumination time.

Amounts of thermal drift: The amount of thermal drift was evaluated based on the distance of movement of the observation field of view during the electron beam illumination time.

The results are described in Table 1.

In both cases of the sample heating holder of the inventive method and the comparative sample heating holder, the amounts of contaminants (the integral C intensities) were large at room temperature but were decreased to the background level when the temperature was raised to 92°C.

On the other hand, the amounts of thermal drift (the distances of movement of the field of view) in both cases were as small as 10 nm at room temperature. However, a marked difference was observed between the holders when the temperature was raised to 92°C. The sample heating holder of the inventive method had as small a drift as 90 nm, the level permitting tracking of the position of image observation or elementary analysis. The drift in the comparative sample heating holder was more than 1000 nm which would make tracking of the position of image observation or elementary analysis infeasible.

From the above, the use of the inventive sample heating method allows the temperature to be automatically controlled to the target temperature only with the need for a connection to a power source (without a specific temperature-controlling circuit). Accordingly, the sample can be heated in such a manner that the occurrence of contaminants on the sample surface can be prevented and the occurrence of a thermal drift can be suppressed. Thus, image observation and elementary analysis can be performed with high accuracy.

**[Table 1]**

| Sample heating | Integral C intensities (cps) | | View field movement distance (nm) | |
|---|---|---|---|---|
| | 28°C | 92°C | 28°C | 92°C |
| Inventive Example | 520 | 9 | 10 | 90 |
| Comparative Example | 511 | 12 | 10 | 1350 |

### [EXAMPLE 2]

Instead of the silicon wafer used in EXAMPLE 1, pure iron (a commercially available plate-shaped standard sample: 99.9% purity) as a sample was immobilized to the sample heating holder, of the inventive method. The amount of contaminants (the integral C intensity) on the sample surface was measured for various durations of electron beam illumination time while performing heating, while performing heating plus the application of oxygen radicals, or while the sample remained untreated without heating. Here, the heating was carried out under the similar conditions as in EXAMPLE 1, and the oxygen radicals were applied with a commercial high-frequency plasma generator. Changes with time of the amount of contaminants were measured for up to an illumination time of 60 minutes in view of the facts that the surface of pure iron was active and more susceptible to the attachment of contaminants than silicon wafers, and the analysis would be inhibited by contaminants if the electron beam had been applied for a prolonged time. The measurement was performed under the similar conditions as in EXAMPLE 1. A plurality of pure iron samples that had been ultrasonically cleaned with acetone were provided, and each sample was analyzed five times for each duration of time, the obtained amounts of contaminants being averaged.

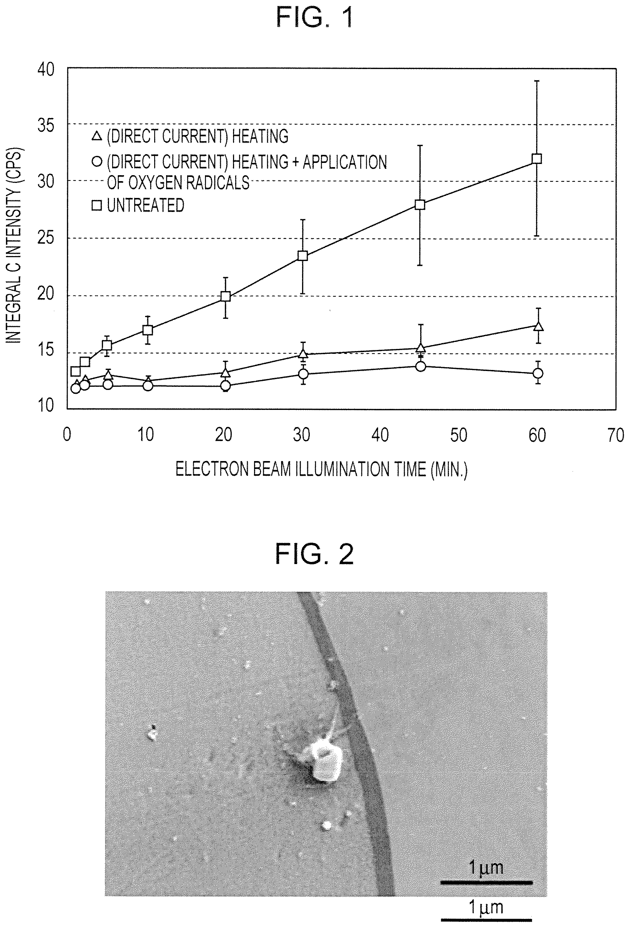

The results are described in Fig. 1.

It has been shown that when the sample is heated with use of the sample heating holder of the inventive method, the increase in the amount of contaminants is significantly suppressed even after 60 minutes of the application of electron beam as compared to when the sample is untreated without heating. Further, it has been illustrated that the amount of contaminants can be reduced more stably by performing heating in combination with the application of oxygen radicals.

### [EXAMPLE 3]

The following test was performed using a sample heating holder of an inventive method similar to that used in EXAMPLE 1 in which a ceramic PTC thermistor having a Curie temperature of 92°C, a service voltage of 100 V and a stable current of 32 mA was immobilized on an existing aluminum sample holder for a scanning electron microscope through a double-sided copper tape (a copper-containing double-sided tape).

A commercially available ultralow carbon steel sheet was etched with Nital, then cleaned with alcohol and dried in air. This steel sheet as a sample was immobilized to the heating section of the sample heating holder through the double-sided copper tape, and the holder was set onto the sample stage of scanning electron microscope SUPRA 55VP manufactured by Carl Zeiss. Image observation was performed with the temperature set at 92°C. Here, the image observation was made while applying a direct current voltage or an alternate current voltage to the sample heating holder via a current inlet terminal mounted on the front side of the SUPRA 55VP sample stage. The scanning electron microscope was operated under the conditions in which accelerating voltage: 5 kV, probe current: 0.1 nA, electron beam illumination time: 500 sec, and observation magnification: x10000. To avoid any influence of charge up, the sample in the sample heating holder was grounded to the aluminum holder through a commercially available conductive Cu tape.

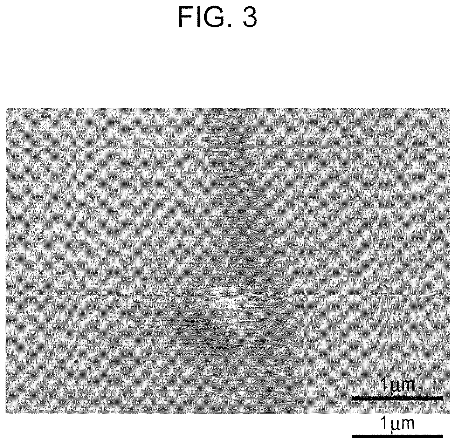

The result of image observation with direct current heating is shown in Fig. 2, and the result of image observation with alternate current heating is given in Fig. 3. It has been illustrated that alternate current heating produces a magnetic field which makes the image very unclear due to the appearance of electric noise in the observed image, whilst direct current heating allows for clear image observation without the appearance of electric noise in the observed image and while preventing the increase of contaminants.

## Claims

1. A method for heating a sample in an electron beam microscope or analyzer in which heat is generated by passing a current through a self-temperature-regulating PTC thermistor which operates non-linearly such that the resistance is increased sharply above the Curie temperature; **characterised in that**:
the PTC thermistor is provided in a sample heating holder;
after the PTC thermistor is provided in the sample heating holder, the sample is immobilized to the sample heating holder; and
a direct current is passed through the PTC thermistor to heat the sample while suppressing the growth of carbon contaminations and the occurrence of a thermal drift during observation and analysis.

2. The method according to claim 1, wherein a plasma or oxygen radicals are applied.

## Patentansprüche

1. Verfahren zum Erwärmen einer Probe in einem Elektronenstrahlmikroskop oder -analysator, bei dem Wärme erzeugt wird, indem ein Strom durch einen selbst temperaturregelnden PTC-Thermistor geleitet wird, der nichtlinear arbeitet, sodass der Widerstand stark über die Curie-Temperatur erhöht wird; **dadurch gekennzeichnet, dass**:
der PTC-Thermistor in einem Probenheizungshalter vorgesehen ist;
nachdem der PTC-Thermistor in der Probenheizungshalterung bereitgestellt wurde, die Probe auf der Probenheizungshalterung fixiert wird; und
ein Gleichstrom durch den PTC-Thermistor geleitet wird, um die Probe zu erwärmen und gleichzeitig das Wachstum von Kohlenstoffverunreinigungen und das Auftreten einer thermischen Drift während der Beobachtung und Analyse zu unterdrücken.

2. Verfahren nach Anspruch 1, bei dem ein Plasma oder Sauerstoffradikale eingesetzt werden.

## Revendications

1. Procédé pour chauffer un échantillon dans un microscope à faisceau électronique ou un dispositif d'analyse où de la chaleur est générée en faisant passer un courant à travers une thermistance PTC (à coefficient de température positif) à régulation de température automatique qui fonctionne de manière non linéaire de sorte que la résistance est augmentée fortement au-dessus de la température de Curie ; **caractérisé en ce que** :
la thermistance PTC est fournie dans un porte-échantillon chauffant ;
après que le thermistor PTC soit fournie dans le porte-échantillon chauffant, l'échantillon est immobilisé sur le porte-échantillon chauffant ; et
un courant continu est amené à traverser la thermistance PTC pour chauffer l'échantillon tout en supprimant la croissance de contaminations au carbone et l'apparition d'une dérive thermique pendant l'observation et l'analyse.

2. Procédé selon la revendication 1, dans lequel un plasma ou des radicaux oxygène sont appliqués.
